Europäisches Patentamt

European Patent Office

Office européen des brevets

(11) Veröffentlichungsnummer: **0 253 016 B1**

(12) **EUROPÄISCHE PATENTSCHRIFT**

(45) Veröffentlichungstag der Patentschrift: **26.02.92**

(21) Anmeldenummer: **86109912.5**

(22) Anmeldetag: **18.07.86**

(51) Int. Cl.⁵: **H03F 3/70**, H03F 1/30, G06G 7/186

(54) **Ladungsverstärkerschaltung.**

(43) Veröffentlichungstag der Anmeldung:
**20.01.88 Patentblatt 88/03**

(45) Bekanntmachung des Hinweises auf die Patenterteilung:
**26.02.92 Patentblatt 92/09**

(84) Benannte Vertragsstaaten:
**AT CH DE FR GB LI**

(56) Entgegenhaltungen:
**GB-A- 1 330 497**
**GB-A- 2 149 248**
**GB-A- 2 162 011**
**US-A- 3 541 319**

**MESURES, Band 37, Nr. 10, Partie 5, Oktober 1972, Seiten 83-90, Paris, FR; F. DATTEE: "Etat actuel de la théorie et des techniques d'application des amplificateurs opération- nels"**

(73) Patentinhaber: **Kistler Instrumente AG**
**Eulachstrasse 22**
**CH-8408 Winterthur(CH)**

(72) Erfinder: **Büsser, Bruno**
**Zielackerstrasse 18**
**CH-8603 Schwerzenbach(CH)**
Erfinder: **Amstutz, Leo**
**Wartgutstrasse 38**
**CH-8413 Neftenbach(CH)**

(74) Vertreter: **Schmidt, Horst, Dr.**
**Siegfriedstrasse 8**
**W-8000 München 40(DE)**

## Beschreibung

Die Erfindung betrifft eine Ladungsverstärkerschaltung gemäss Oberbegriff des Patentanspruches 1.

Ladungsverstärker zur Verwendung als Messchaltung beispielsweise in Verbindung mit piezoelektrischen Messgebern haben die nachteilige Eigenschaft, dass ihre Ausgangsspannung mit einer Nullpunktablage und einer Drift behaftet ist, welche eine Messung störend beeinflussen können. Das Ausmass der Auswirkungen auf die Messgenauigkeit ist von der Qualität des Eingangskreises und der Eingangsstufe des Ladungsverstärkers abhängig. Unter anderem muss die Eingangsstufe einen extrem hohen Eingangswiderstand (z.B. $10^{14}$ Ohm) aufweisen. Die Nullpunktablage der Ausgangsspannung ist bei einem Ladungsverstärker mit einer stabilen, z.B. aus J-FET aufgebauten Eingangsstufe verhältnismässig gering und stabil. Derartige Eingangsstufen weisen aber in der Regel nicht zu vernachlässigende und ausserdem stark temperaturabhängige Leckströme auf, welche eine Drift der Ausgangsspannung verursachen. Demgegenüber haben aus z.B. MOSFET aufgebaute Eingangsstufen geringere Leckströme, und damit ausgerüstete Ladungsverstärker zeigen demzufolge eine geringere Drift der Ausgangsspannung und eignen sich somit auch für quasistationäre Messungen, wobei in den meisten Fällen auf eine Driftkompensation verzichtet werden kann. MOSFET-Eingangsstufen haben jedoch eine verhältnismässig schlechte Stabilität. Dieser Umstand hat zur Folge, dass die Nullpunktablage der Ausgangsspannung des Ladungsverstärkers zeitlichen und thermischen Schwankungen unterworfen ist, welche für genaue Messungen ein häufiges, mit erheblichem Zeitaufwand verbundenes Korrigieren erfordern.

Es sind Gleichstromverstärker bekannt, bei denen eine Korrektur der Nullpunktablage und andere Fehlerkorrekturen durch ein- oder mehrmaliges Rückführen eines Signals an den Verstärkereingang nach einer vorgängigen Zuführung des zu verstärkenden Signals erreicht werden kann (DE-C-15 62 070 und 24 32 404). Um die aufeinanderfolgenden Arbeitsphasen einer oder mehrerer Verstärkerstufen zu verwirklichen, sind wenigstens eine Speicherschaltung, wenigstens eine Rückkopplungsschleife und mehrere periodisch arbeitende Schalter vorgesehen. Abgesehen von dem verhältnismässig hohen schaltungstechnischen Aufwand, sind derartige Schaltungsanordnungen für die Verwendung in einer Ladungsverstärkerschaltung mit sehr hochohmiger Eingangsstufe nicht geeignet. Insbesondere würden Schaltvorgänge im Eingangskreis des Ladungsverstärkers und zusätzliche, durch Rückkopplungsschleifen verursachte Belastungen des Verstärkereinganges während der Messphase den Messvorgang störend beeinflussen.

Aus der AT-C-377 132 ist zwar eine Ladungsverstärkerschaltung bekannt, bei der während der Rückstellphase eine von der Ausgangsspannung abgeleitete Korrekturgrösse an den Eingang des Ladungsverstärkers zurückgeführt wird, welche in der anschliessenden Messphase zur Wirkung kommt. Es handelt sich hierbei aber um eine Driftkompensation, wobei mit einem Korrekturstrom die Leckströme im Eingangskreis des Ladungsverstärkers kompensiert werden. Damit der Korrekturstrom während der Messphase erhalten bleibt, muss ein D/A-Wandler mit dem Eingang des Ladungsverstärkers dauernd verbunden sein. Eine derartige Schaltungsanordnung kann deshalb wegen der zusätzlichen Belastung des Eingangskreises während der Messphase, vor allem bei dynamischen Vorgängen, bei einem Ladungsverstärker mit hochohmiger Eingangsstufe zu Messfehlern führen. Im übrigen ist für die Driftkompensation nach der AT-C-377 132 ein verhältnismässig hoher Aufwand erforderlich.

Ferner ist es bekannt, bei einem als Integrator arbeitenden Operationsverstärker dem Integrationskondensator vor einer Messphase eine Anfangsladung vorzugeben (U. Tietze & Ch. Schenk, Halbleiter-Schaltungstechnik, 3. Auflage, 1974, Seiten 241 und 242). Zu diesem Zweck wird bei abgeschalteter Signalquelle der Integrationskondensator durch eine separate Spannungsquelle aufgeladen. Eine Rückführung der Ausgangsspannung des Verstärkers zur Erzeugung einer Anfangsladung für Korrekturzwecke ist jedoch nicht vorgesehen. Im übrigen ist eine Abschaltung der Signalquelle während der Rückstellphase aus bereits genannten Gründen nicht erwünscht.

Aus der GB-A-1 330 497 ist ferner eine Ladungsverstärkerschaltung bekannt, die als Steuerschaltung zum Einsatz bei Kathodenstrahloszillographen oder zur Bewegungssteuerung eines beweglichen Maschinenteiles dient und ein elektrisches Spannungssignal schafft, das sich über eine Zeitdauer unmittelbar nach einer vorhergehenden Zeitdauer, während der die Spannung konstant bleibt, proportional mit der Zeit ändert. Die Relaxationszeit für die Rückstellung des Spannungsnullpunktes eines Integrationsverstärkers dieser bekannten Schaltung durch Kurzschliessen eines Integrationskondensators mittels einer Feedbackschleife ist für eine hochohmige Eingangsspannung, wie sie in Verbindung mit piezoelektrischen Messaufnehmern vorliegen, zu lange, um die beim Messen mit piezoelektrischen Aufnehmern auftretenden raschen und beträchtlichen Nullpunktsabweichungen kompensieren zu können. Die bekannte Ladungsverstärkerschaltung eignet sich daher nicht als Messchaltung zum Einsatz beispielsweise in Verbindung mit piezoelektrischen Aufnehmerelementen.

Der Erfindung liegt die Aufgabe zugrunde, eine Ladungsverstärkerschaltung der eingangs erwähnten Art zu schaffen, die in Verbindung mit hochohmigen Eingangsstufen verwendbar ist und eine automatische Kompensation der Nullpunktablage der Ausgangsspannung bewirkt.

Diese Aufgabe wird durch die Merkmale des Patentanspruches 1 gelöst. Bei der erfindungsgemäss als Messchaltung ausgebildeten Ladungsverstärkerschaltung ist der Integrationskondensator über eine Rückstelleinrichtung durch einen Widerstand überbrückbar, so dass dem Integrationskondensator bei aktivierter Rückstelleinrichtung automatisch eine Korrekturladung zugeführt wird, welche während der auf die Rückstellphase folgenden Messphase die Nullpunktablage der Ausgangsspannung der Ladungsverstärkerschaltung kompensiert.

Die Erfindung schafft daher mit verhältnismässig einfachen Mitteln und geringem Aufwand eine Messchaltung mit extrem hochohmiger Eingangsstufe, die eine automatische Korrektur der Nullpunktablage durchführt. Der vorhandene Integrationskondensator macht separate Speicherschaltungen überflüssig. Eine Unterbrechung des Eingangssignals und eine zusätzliche Belastung des Verstärkereingangs werden vermieden. Bei der Rückstelleinrichtung handelt es sich vorzugsweise um einen hochisolierenden Schalter (z.B. ein Reed-Relais), der im geschlossenen Zustand die beiden Widerstände mit dem invertierenden Eingang des ersten oder Operationsverstärkers verbindet.

Die Relaxationszeit der Rückstellphase wird durch die Überbrückung der Kapazität mittels des parallel liegenden Widerstandes wesentlich verkürzt, was den Einsatz der Ladungsverstärkerschaltung als Messchaltung mit einer hochohmigen bis extrem hochohmigen Eingangsstufe ermöglicht. Demzufolge ist gemäss einer Weiterbildung der Erfindung dem ersten Operationsverstärker vorzugsweise eine Folgeverstärker nachgeordnet.

Die erzielte Genauigkeit der automatischen Korrektur der Nullpunktablage hängt auch von den Nullpunktdaten des zweiten oder Korrekturverstärkers ab. Es ist daher vorteilhaft, wenn gemäss einer anderen Weiterbildung der Erfindung der zweite Verstärker ein Operationsverstärker ist, dessen Nullpunktablage der Ausgangsspannung kleiner und stabiler als diejenige des ersten Verstärkers ist. Der Frequenzgang des zweiten oder Operationsverstärker ist dagegen nicht kritisch, da die Rückstellphase verhältnismässig lange dauert und die Nullpunktverschiebungen im allgemeinen relativ langsam ablaufen. Die den zweiten oder Operationsverstärker enthaltende Regelschleife ist ferner vorzugsweise zusätzlich durch ein Integrationsglied stabilisiert. Gemäss einer anderen Weiterbildung der Erfindung kann am nicht invertierenden Eingang des ersten Operationsverstärkers ein veränderbares Potential angelegt sein.

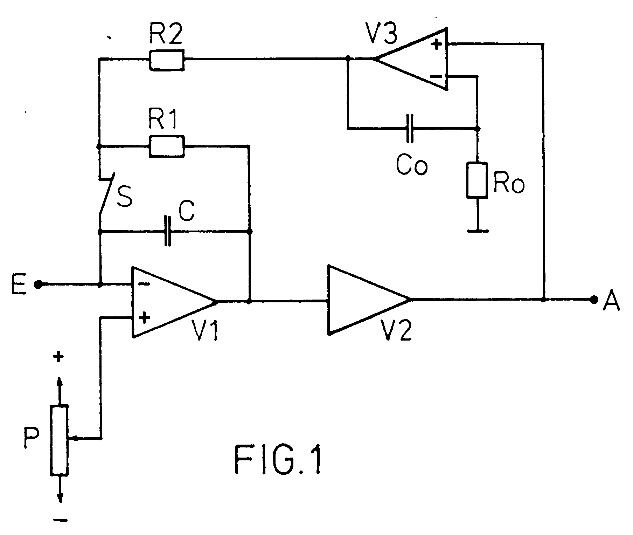

Die Erfindung wird nachfolgend anhand der Zeichnung, die ein Ausführungsbeispiel einer erfindungsgemäss aufgebauten Schaltung zeigt, näher erläutert.

Die dargestellte Ladungsverstärkerschaltung umfasst einen als Ladungsverstärker betriebenen Operationsverstärker V1 mit einem Integrationskondensator C zwischen seinem Ausgang und seinem invertierenden Eingang und mit einer den Schalter S aufweisenden Rückstelleinrichtung, ferner einen Folgeverstärker V2 sowie eine Schaltungsanordnung mit einem Korrekturverstärker V3.

Der Schalter S der Rückstelleinrichtung ist für die Dauer der Messphase geöffnet und für die Dauer der Rückstellphase geschlossen. Bei geschlossenem Schalter S ist der Integrationskondensator C durch einen Widerstand R1 überbrückt, der während der Rückstellphase zur Entladung des Integrationskondensators C dient. Während der Messphase nimmt der Integrationskondensator C die zu messende, dem Eingang E der Ladungsverstärkerschaltung zugeführte Ladung auf, für die die Spannung am Ausgang A der Ladungsverstärkerschaltung ein Mass darstellt.

Am nichtinvertierenden Eingang des Operationsverstärkers V1 liegt ein veränderbares Potential, das von einem an eine Spannungquelle angeschlossenen Potentiometer P abgegriffen wird. Mit diesem Potentiometer P lässt sich während der Rückstellphase die Nullpunktablage der Spannung am Ausgang A der Ladungsverstärkerschaltung kompensieren. Damit nun die für eine genaue Messung vor jeder Messphase erforderliche Korrektur in bezug auf die Kompensation der Nullpunktablage nicht manuell erfolgen muss, was nur von fachkundigem Bedienungspersonal zuverlässig vorgenommen werden kann, ist nach der Erfindung eine automatische Kompensation der Nullpunktablage vorgesehen. Das Potentiometer P dient dabei nur noch zur Grobkorrektur, z.B. bei der Werkseinstellung der Ladungsverstärkerschaltung.

Der Ausgang A der Ladungsverstärkerschaltung ist mit dem nichtinvertierenden Eingang des Korrekturverstärkers V3 verbunden, dessen Ausgang bei geschlossenem Schalter S über den Widerstand R2 an den Eingang E der Ladungsverstärkerschaltung zurückgeführt ist. Auf diesem Weg wird dem Integrationskondensator C während jeder Rückstellphase eine der Spannung am Ausgang A proportionale Korrekturladung zugeführt, welche während der auf die Rückstellphase folgenden Messphase die Nullpunktablage der Ausgangsspannung der Ladungsverstärkerschaltung automatisch kompensiert.

Damit der bei der Korrektur auftretende Restfehler möglichst klein bleibt, dient als Korrekturverstärker V3 ein Operationsverstärker, dessen Nullpunktablage der Ausgangsspannung wesentlich kleiner und stabiler ist als jene des den Ladungsverstärker bildenen Operationsverstärkers V1.

Der Kondensator Co und der Widerstand Ro bilden ein mit dem Korrekturverstärker V3 zusammenwirkendes Integrationsglied zur Stabilisierung der über den Korrekturverstärker V3 führenden Regelschleife. Mit dieser Massnahme wird auch eine Verminderung des Rauschens erreicht.

**Patentansprüche**

1. Ladungsverstärkerschaltung mit einem ersten Operationsverstärker (V1), einem Integrationskondensator (C) zwischen dem invertierenden Eingang und dem Ausgang des ersten Verstärkers, und einem zweiten Verstärker (V3), dessen Eingang mit dem Ausgang der Ladungsverstärkerschaltung und dessen Ausgang über einen Widerstand (R2) und eine Rückstelleinrichtung während der Rückstellphase mit dem invertierenden Eingang des ersten Verstärkers verbunden ist, dadurch gekennzeichnet, dass die Ladungsverstärkerschaltung als Messchaltung ausgebildet ist, indem der Integrationskondensator (C) über die Rückstelleinrichtung durch einen Widerstand (R1) überbrückbar ist, so dass dem Integrationskondensator bei aktivierter Rückstelleinrichtung automatisch eine Korrekturladung zugeführt wird, welche während der auf die Rückstellphase folgenden Messphase die Nullpunktablage der Ausgangsspannung der Ladungsverstärkerschaltung kompensiert.

2. Schaltung nach Anspruch 1, dadurch gekennzeichnet, dass dem ersten Verstärker (V1) ein Folgeverstärker (V2) nachgeordnet ist.

3. Schaltung nach Anspruch 1 oder 2, dadurch gekennzeichnet, dass der zweite Verstärker (V3) ein Operationsverstärker ist, dessen Nullpunktablage der Ausgangsspannung kleiner und stabiler als diejenige des ersten Verstärkers (V1) ist.

4. Schaltung nach Anspruch 1, 2 oder 3, dadurch gekennzeichnet, dass am nicht invertierenden Eingang des ersten Verstärkers (V1) ein veränderbares Potential angelegt ist.

**Claims**

1. A Charge amplifying circuit including a first operational amplifier (V1), an integrating capacitor (C) connected between the inverting input and the output of said first amplifier, and a second amplifier (V3) whose input being connected with the output of said charge amplifying circuit and whose output during a reset phase being connected through a resistance (R2) and a reset means with the inverting input of said first amplifier, characterized in that said charge amplifying circuit being formed as a measuring circuit in that said integrating capacitor (C) is adapted to be by-passed by said reset means by means of a resistance (R1), whereby a correcting charge is automatically supplied to the integrating capacitor when said reset means is activated, said correcting charge during a measuring phase following the reset phase compensates the output voltage of the charge amplifying circuit.

2. The charge amplifying circuit according to claim 1, characterized in that said first amplfier (V1) is followed by a sequence amplifier (V2).

3. The charge amplifying circuit according to claim 1 or 2, characterized in that said second amplifier (V3) being an operational amplifier whose zero offset of the output voltage being smaller and more stable than that of the first amplifier (V1).

4. The carge amplifying circuit according to claim 1, 2 or 3, characterized in that a potential adapted to be varied being connected with the non-inverting input of said first amplifier (V1).

**Revendications**

1. Circuit d'amplification de charge avec un premier amplificateur fonctionnel (V1), un condensateur d'intégration (C) entre l'entrée d'inversion et la sortie du premier amplificateur et un deuxième amplificateur (V3) dont l'entrée est connectée à la sortie du circuit d'amplification de charge et dont la sortie est connectée par une résistance (R2) et un dispositif de remise pendant la phase de remise à zéro avec l'entrée à inversion du premier amplificateur, caractérisé en ce que le circuit d'amplification de charge est réalisé sous forme d'un circuit de mesure, dans lequel le condensateur d'intégration (C) peut être bypassé au-delà du dispositif de remise à zéro par une résistance (R1), si bien qu'une charge de correction est appliquée automatiquement au condensateur d'intégration quand le dispositif de remise à zéro est activé, cette charge compensant, pendant la phase de mesure suivant la phase de remise à zéro, la dérive du zéro de la tension de sortie du circuit d'amplification de charge.

2.  Circuit selon la revendication 1, caractérisé en ce qu un amplificateur auxiliaire (V2) est monté après le premier amplificateur (V1).

3.  Circuit selon la revendication 1 ou 2, caractérisé en ce que le deuxième amplificateur (V3) est un amplificateur fonctionnel dont la dérive du point zéro de la tension de sortie est plus faible et plus stable que celle du premier amplificateur (V1).

4.  Circuit selon les revendications 1, 2 ou 3, caractérisé en ce qu'un potentiel variable est appliqué à l'entrée sans inversion du premier amplificateur (V1).

FIG.1